# EUROPEAN PATENT APPLICATION

(11) **EP 1 753 280 A2**
(43) Date of publication of application: **14.02.2007**
(21) Application number: 06014937.4
(22) Date of filing: 18.07.2006
(51) Int. Cl.: H05K 7/14, H05K 5/06

(54) **Printed circuit board/sheathing bond structure**

(30) Priority: 18.07.2005 US 183632
(71) Applicant: Prager, Helmut, 64521 Gross-Gerau (DE)
(72) Inventor: Prager, Helmut, 64521 Gross-Gerau (DE)
(74) Representative: Jung HML

(57) **Abstract**

The invention relates to a printed circuit board/sheathing bond structure with a sheathing enclosing a printed circuit board (11) and comprised of two plastic-half-shells (12, 13) whose edges are closely bonded to each other in order to hermetically seal the printed circuit board (11).

## Description

The invention relates to a printed circuit board/sheathing bond structure with sheathing that encloses a printed circuit board.

There are several known types of circuit board sheathing, which protects printed circuit boards from environmental effects such as humidity, dust, etc. According to one proposal, the printed circuit board is encapsulated in a plastic shell with resin or silicone. However, the cast resins used are injurious to health. The printed circuit board and cast resin combination is problematic in terms of its disposal. The cast resin penetrating in between the components during encapsulation may damage sensitive components such as pushbuttons and electroacoustical components like piezoelectric or dynamic buzzers. Another known method is to insert the printed circuit board in a sealable plastic pouch. This involves a mechanically unstable protective measure for the printed circuit board, in that precise positive fit with external mechanical components is difficult to achieve. There is also the risk of humidity reaching intractable cable bushings. Yet another method is to protect the printed circuit board surface with a coat of lacquer. With this method the printed circuit board is at least temporarily, but still inadequately, protected because of cracking in the lacquer at exposed points such as trimmed wire ends. In addition, the penetration of lacquer and/or humidity into mechanical and electroacoustical components is difficult to avoid. Another procedure to be considered is to encapsulate the printed circuit board with a heat-shrinkable sleeve or to extrusion-coat the printed circuit board with a thermoplastic polymer that melts at low temperature. Encapsulating the printed circuit board with a heat-shrinkable sleeve leads to insufficient sealing on the face. Because of the hardness and tightness of the heat-shrinkable sleeve, the transmission of forces through it-say, with an actuating plunger on a pushbutton-is difficult to implement. Finally, the thermoplastic extrusion-coating of printed circuit boards is a very costly procedure, requiring expensive tooling and processing machininery and risking thermal damage or destruction of the coated components.

In view of this state of the art, the invention has the task of creating a printed circuit board/sheathing bond structure which is cost-effective and involves little investment, is environmentally friendly, durable and robust, and poses no risk to health.

The characteristics of Claim 1 resolve this task. The dependent claims describe advantageous further embodiments.

The invention involves sheathing for the printed circuit board consisting of a hermetically sealed housing produced by bonding the edges of two half-shell molds made of plastic material. This provides reliable protection for the printed circuit board from environmental effects such as humidity and dust.

The manufacturing process used for the two half-shells of the hermetically sealed housing is a deep-drawing process that costs little in terms of tooling and processing machinery.

From cost considerations and because of its harmlessness to health, a suitable material for the half-shell is a plastic sheet made of PVC, PET, PETG or A-PET. The preferred thickness of the plastic sheet is between 0.1 and 0.5 mm, with a recommended thickness of about 0.3 mm. Alternatively, the thickness of the plastic sheet could be between 0.3 and 1.5 mm, with a recommended thickness of about 0.6 mm. With appropriate die-work, these plastic films ensure mechanical stability and allow transfer of manual operating forces, for example, to the actuating mechanism of pushbuttons. An appropriate design element for such a half-shell is designed with an elastic contour, usually a dome-shaped pushbutton profile.

If the plastic sheet is made transparent or translucent, optical signals can be transmitted through it, that is, external optical signals can be received by a receiver on the printed circuit board and transmitted outwards by a transmitter (for example, an LED on the printed circuit board).

In addition, because of good acoustical transmission properties of the sheet housing, sound generated by a buzzer on the printed circuit board can be emitted to the surroundings by the plastic sheet with its tightly enclosed air volume with minor attenuation.

The double-shell housing described in the invention is also suitable for a hermetically sealed bushing of wires. Plastic-sheathed wires can thus be conveyed through the half-shell edges and, because of their plastic sheathing, can be hermetically sealed and integrated into the sealing points that appear when the half-shell edges are bonded. This means that the plastic sheathing fuses together as the half-shell edges bond with the material of the half-shells, forming a hermetically sealed cable bushing.

Alternatively, wires can pass through an opening or openings with a cross-section adapted to the wire's cross section in one half-shell of the printed circuit board sheathing, which is caulked with a suitable sealant such as resin or silicone.

The invention is described in more detail in the drawing below; where
Fig. 1 shows a top view of an embodiment of the printed circuit board/sheathing bond structure according to the invention before the sealing of a cable bushing,
Fig. 2 shows a view of Fig. 1 from below, and
Fig. 3 shows the printed circuit board/sheathing bond structure in the same view as in Fig. 1 with the wire opening sealed.

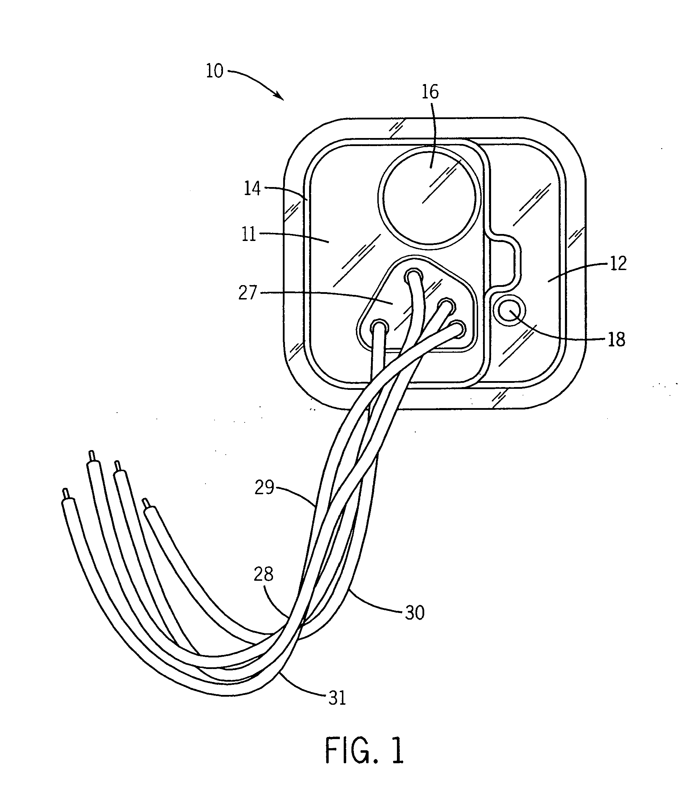

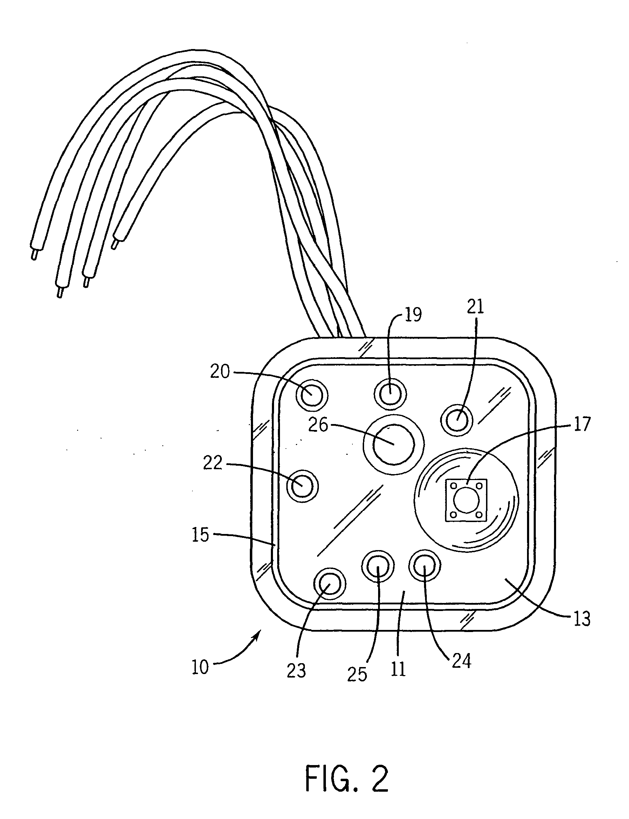

An embodiment of a printed circuit board/sheathing bond structure is shown in Fig. 1 to 3 under reference number 10. The printed circuit board/sheathing bond structure 10 encloses a printed circuit board 11, equipped on both sides with circuit components and sealed by a sheathing that comprises two plastic half-shells 12 and 13, which are manufactured by a deep-drawing process from a thermally bondable plastic sheet.

To facilitate optical signal penetration, a transparently or translucently constructed plastic sheet, preferably made of PVC, PET, PETG or A-PET, is recommended. The preferable thickness of the plastic sheet is between 0.1 and 0.5 mm, with the recommended thickness about 0.3 mm. Alternatively, the plastic sheet can have a thickness between 0.3 and 1.5 mm, and a recommended thickness of about 0.6 mm.

The edges of the two half-shells 12 and 13 are hermetically sealed and bonded to each other. For this purpose, and to correctly position the two half-shells 12, 13 relative to each other during assembly and to keep them in contact for the bonding, the two half-shells 12 and 13 have in their circumference a positive-locking edge structure with profile edges 14 and 15 that lock into each other. The edge locking is attained by the appropriate construction of profile edges 14, 15 with meshing and mateable or male and female profile sections.

The circumferential edge of printed circuit board 11 borders on the inner edge of the edge structure of the half-shells 12, 13. For the rest, the contour of the half-shells 12, 13-inward from the edge structure-follows the circuit components, rising at different heights over the top face of the printed circuit board; for instance, a cylindrical component on the upper face of the printed circuit board 11, whose upper end is encapsulated on top by a protruding cylindrical section 16 of the half-shell 12 (Fig. 1).

A similar elevated protruding section 17 is provided on the half-shell 13 above a pushbutton mounted on the underside of the printed circuit board 11. This section 17 has a dome-shaped design and, if necessary, is made thinner than the rest of the half-shell 13 in order to facilitate a snapback, pressable load-transmitting function for the manual activation of the pushbutton.

In both half-shell 12 and half-shell 13 there are indentations 18-25, which bear against the printed circuit board 11, fixing its position inside the sheathing in the direction of thickness.

Additionally, the two half-shells 12, 13 have a bond joint inside their bonded edge structure. This bond joint encompasses an indentation 26 in the half-shell 13, protruding through an opening in the printed circuit board 11 and extending up to a section of the half-shell 12 at the base of a bowl-shaped indentation 27. Indentations 26 and 27 are bonded to each other at their contact points.

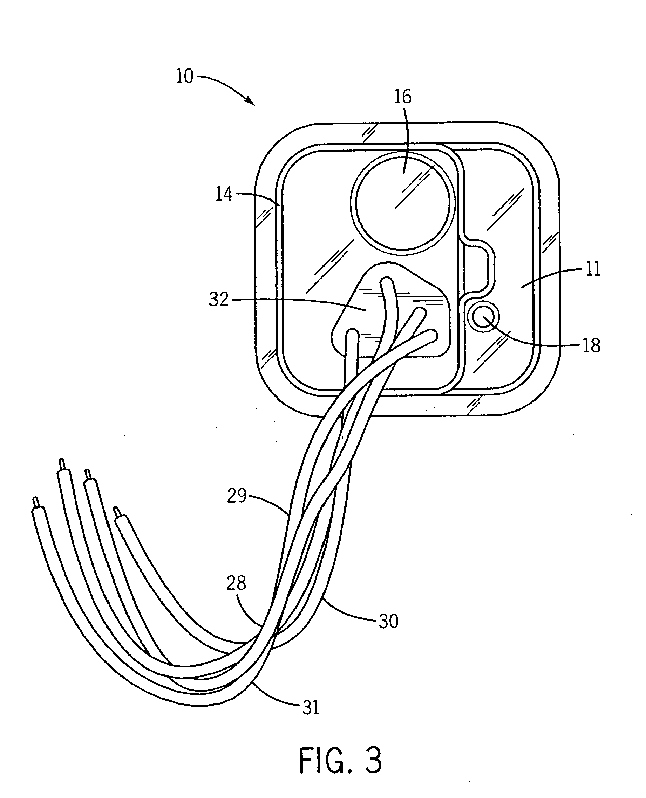

In the bowl-shaped indentation 27 are four holes that serve as cable bushings for four connecting leads 28-31 bonded to the printed circuit board. As shown in Fig. 3, holes are hermetically sealed and caulked using a sealant 32 such as silicone or resin after the connecting leads 28-31 pass through them.

## Claims

1. Printed circuit board/sheathing bond structure with a sheathing, enclosing a printed circuit board (11) and comprised of two plastic half-shells (12, 13) whose edges are closely bonded to each other.

2. Printed circuit board/sheathing bond structure according to Claim 1, **characterized in that** the two half-shells (12, 13) have a circumferential edge (14, 15).

3. Printed circuit board/sheathing bond structure according to Claims 1 or 2, **characterized in that** both half-shells (12, 13) have a positive-locking edge structure that lock against each other (14, 15).

4. Printed circuit board/sheathing bond structure according to one of Claims 1 to 3, **characterized in that** at least one of the two half-shells (12, 13) has at least one impression (18-25) to support this half-shell (12, 13) on the printed circuit board (11).

5. Printed circuit board/sheathing bond structure according to one of Claims 1 to 4, **characterized in that** at least one half-shell (12, 13) has a protrusion (16, 17) that follows the outline contour of at least one component on the printed circuit board (11).

6. Printed circuit board/sheathing bond structure according to Claim 5, **characterized in that** the half-shell (13) has a reduced wall thickness in the area of a mechanically controllable component on the printed circuit board (11), for instance, a pushbutton.

7. Printed circuit board/sheathing bond structure according to one of Claims 1 to 6, **characterized in that** at least one of the two half-shells (12, 13) is at least partially transparent or translucent in order to let light pass through.

8. Printed circuit board/sheathing bond structure according to one of Claims 1 to 7, **characterized in that** at least one of the half-shells (12) has a compound-filled opening or an opening caulked with sealant (32) where a connecting lead (28-31) can pass through.

9. Printed circuit board/sheathing bond structure according to one of Claims 1 to 9, **characterized in that** a connecting lead passes through the edge structure (14, 15) of both half-shells (12, 13), and that the sheathing of the lead is closely bonded to the edge structure (14, 15).

10. Printed circuit board/sheathing bond structure according to one of Claims 1 to 9, **characterized in that** both half-shells consist of deep-drawn plastic sheet.

11. Printed circuit board/sheathing bond structure according to Claim 10, **characterized in that** the plastic sheet is made of PVC, PET, PETG or A-PET.

12. Printed circuit board/sheathing bond structure according to Claim 10 or 11, **characterized in that** the plastic sheet has a thickness ranging between 0.1 and 0.5 mm, with a recommended thickness of about 0.3 mm.

13. Printed circuit board/sheathing bond structure according to Claim 10 or 11, **characterized in that** the plastic sheet has a thickness ranging between 0.3 and 1.5 mm, with a recommended thickness of about 0.6 mm.

14. Printed circuit board/sheathing bond structure according to one of Claims 1 to 13, **characterized in that** both half-shells (12, 13) are bonded to each other inside their edge structure (14, 15) through an opening in the printed circuit board (11).

15. Printed circuit board/sheathing bond structure according to one of Claims 1 to 14, **characterized in that** both half-shells (12, 13) are contact-bonded to each other.

16. Printed circuit board/sheathing bond structure according to one of Claims 1 to 13, **characterized in that** the edge of the printed circuit board borders on the inner edge of the edge structure (14, 15) of the half-shells (12, 13).
